# EUROPEAN PATENT APPLICATION

(11) **EP 4 704 533 A1**
(43) Date of publication of application: **04.03.2026**
(21) Application number: 25198518.0
(22) Date of filing: 27.08.2025
(51) Int. Cl.: H10K 50/844, H10K 59/80

(54) **DISPLAY APPARATUS AND ELECTRONIC DEVICE INCLUDING THE SAME**

(30) Priority: 30.08.2024 KR 20240117881
(71) Applicant: Samsung Display Co., Ltd., Yongin-si, Gyeonggi-do 17113 (KR)
(72) Inventor: KIM, Changmok, 17113 Yongin-si (KR); KWACK, Jinho, 17113 Yongin-si (KR)
(74) Representative: Aldridge, Henry Alexander

(57) **Abstract**

A display apparatus includes a display element on a substrate, and an encapsulation layer covering the display element. The encapsulation layer includes a first inorganic encapsulation layer, a second inorganic encapsulation layer, and an organic encapsulation layer between the first inorganic encapsulation layer and the second inorganic encapsulation layer. The organic encapsulation layer has a relative permittivity of 2.3 to 2.7, and the second inorganic encapsulation layer has a density of greater than 1.8 g/cm³ and less than 2.03 g/cm³.

## Description

This application claims priority to Korean Patent Application No. 10-2024-0117881, filed on August 30, 2024.

### BACKGROUND

### 1. Field

One or more embodiments relate to a display apparatus and an electronic device including the same, and more particularly, to a display apparatus, in which the possibility of defects occurring during a manufacturing process is reduced, and an electronic device including the same.

### 2. Description of the Related Art

Recently, the usage of display apparatuses has diversified. Also, as display apparatuses have become thinner and more lightweight, the use thereof has expanded. As the use of display apparatuses has diversified, various methods of designing the form of display apparatuses have been studied.

A display apparatus may display an image by using a display element including a pixel electrode, an opposite electrode, and an emission layer between the pixel electrode and the opposite electrode. Because the display element may be easily damaged by ambient moisture or oxygen, an encapsulation layer may cover the display element so as to protect the display element. The encapsulation layer may include at least one inorganic encapsulation layer and at least one organic encapsulation layer. On the other hand, the display apparatus may further include a touch sensor so as to receive information from the outside through a touch of a user on a display screen.

### SUMMARY

However, in a conventional display apparatus, when an organic encapsulation layer included in an encapsulation layer has a low relative permittivity so as to prevent the performance of a touch sensor from being degraded by a capacitance between the touch sensor and an opposite electrode of a display element, the organic encapsulation layer may be separated from an inorganic encapsulation layer on the organic encapsulation layer, or wrinkles may occur in the organic encapsulation layer.

One or more embodiments include a display apparatus, in which the possibility of defects occurring during a manufacturing process is reduced, and an electronic device including the same. However, this is only an example and embodiments of the disclosure are not limited thereby.

Additional aspects will be set forth in part in the description which follows and, in part, will be apparent from the description, or may be learned by practice of the presented embodiments of the disclosure.

According to one or more embodiments, a display apparatus includes a display element on a substrate, and an encapsulation layer covering the display element. The encapsulation layer includes a first inorganic encapsulation layer, a second inorganic encapsulation layer, and an organic encapsulation layer between the first inorganic encapsulation layer and the second inorganic encapsulation layer, the organic encapsulation layer has a relative permittivity of 2.3 to 2.7, and the second inorganic encapsulation layer has a density of greater than 1.8 gram per cubic centimeters (g/cm³) and less than 2.03 g/cm³.

The second inorganic encapsulation layer may be in direct contact with the organic encapsulation layer.

The second inorganic encapsulation layer may have a compressive stress of greater than 60 megapascals (MPa) and less than 180 MPa.

The second inorganic encapsulation layer may include at least one of silicon nitride or silicon oxynitride.

When the second inorganic encapsulation layer is exposed as an outermost layer of the display apparatus at a temperature of 85 degrees in Celsius (°C) and a humidity of 85 % for 504 hours, the second inorganic encapsulation layer may have an oxidation rate of greater than 0.7 angstroms per hours (Å/h) and less than 2.3 Å/h. In other words, the second inorganic encapsulation layer may be configured so as to have an oxidation rate of greater than 0.7 angstroms per hours (Å/h) and less than 2.3 Å/h when exposed as an outermost layer of the display apparatus at a temperature of 85 degrees in Celsius (°C) and a humidity of 85 % for 504 hours.

The organic encapsulation layer may have a modulus of greater than 60 MPa and less than 1 gigapascal (GPa).

The display apparatus may further include a touch sensor layer on the encapsulation layer.

The touch sensor layer may include a touch conductive layer and a touch insulating layer covering the touch conductive layer.

The first inorganic encapsulation layer may include at least one of silicon oxide, silicon nitride, or silicon oxynitride.

The display apparatus may further include a third inorganic encapsulation layer on the second inorganic encapsulation layer. The third inorganic encapsulation layer may have a density higher than the density of the second inorganic encapsulation layer.

The third inorganic encapsulation layer may have a density of 2.03 g/cm3 to 2.2 g/cm3.

According to one or more embodiments, an electronic device may comprise a display apparatus, and a housing accommodating the display apparatus and forming an exterior of the electronic device. The display apparatus may be any of the display apparatuses discussed herein.

According to one or more embodiments, a display apparatus includes a display element on a substrate, and an encapsulation layer covering the display element. The encapsulation layer includes a first inorganic encapsulation layer, a second inorganic encapsulation layer, an organic encapsulation layer between the first inorganic encapsulation layer and the second inorganic encapsulation layer, and a third inorganic encapsulation layer on the second inorganic encapsulation layer, the organic encapsulation layer has a relative permittivity of 2.3 to 2.7, the second inorganic encapsulation layer has a density of greater than 1.8 g/cm³ and less than 2.03 g/cm³, and the third inorganic encapsulation layer has a density higher than the density of the second inorganic encapsulation layer.

The second inorganic encapsulation layer may be in direct contact with the organic encapsulation layer.

The second inorganic encapsulation layer may have a compressive stress of greater than 60 MPa and less than 180 MPa.

The second inorganic encapsulation layer may include at least one of silicon nitride or silicon oxynitride.

When the second inorganic encapsulation layer is exposed as an outermost layer of the display apparatus at a temperature of 85 °C and a humidity of 85 % for 504 hours, the second inorganic encapsulation layer may have an oxidation rate of greater than 0.7 Å/h and less than 2.3 Å/h.

The organic encapsulation layer may have a modulus of greater than 60 MPa and less than 1 GPa.

The display apparatus may further include a touch sensor layer on the encapsulation layer.

The touch sensor layer may include a touch conductive layer and a touch insulating layer covering the touch conductive layer.

The first inorganic encapsulation layer may include at least one of silicon oxide, silicon nitride, or silicon oxynitride.

The third inorganic encapsulation layer may have a density of 2.03 g/cm³ to 2.2 g/cm³.

According to one or more embodiments, an electronic device includes a display apparatus, and a housing accommodating the display apparatus and forming an exterior of the electronic device, where the display apparatus includes a display element on a substrate, and an encapsulation layer covering the display element. The encapsulation layer including a first inorganic encapsulation layer, a second inorganic encapsulation layer, and an organic encapsulation layer between the first inorganic encapsulation layer and the second inorganic encapsulation layer, the organic encapsulation layer has a relative permittivity of 2.3 to 2.7, and the second inorganic encapsulation layer has a density of greater than 1.8 g/cm³ and less than 2.03 g/cm³.

According to an aspect, there is provided a display device as set out in claim 1. Additional features are set out in claims 2 to 11.

According to an aspect, there is provided an electronic device as set out in claim 12.

Other aspects, features, and advantages of the disclosure will become apparent from the following detailed description, the claims, and the drawings for carrying out the disclosure.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic perspective view of an electronic device according to an embodiment;
FIG. 2 is a schematic plan view of a display apparatus according to an embodiment;
FIG. 3 is a schematic side view of a display apparatus according to an embodiment;
FIG. 4 is a schematic plan view illustrating a portion of a touch sensor layer of FIG. 3;
FIG. 5 is an enlarged plan view of region A of FIG. 4;
FIG. 6 is an equivalent circuit diagram of a pixel circuit included in the display apparatus of FIG. 2;
FIG. 7 is a schematic cross-sectional view of the display apparatus of FIG. 2 taken along line I-I' of FIG. 2; and
FIG. 8 is a schematic cross-sectional view illustrating a portion of a display apparatus according to an embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present description allows for various changes and numerous embodiments, certain embodiments will be illustrated in the drawings and described in detail in the written description. Effects and features of the disclosure, and methods of achieving them will be clarified with reference to embodiments described below in detail with reference to the drawings. However, embodiments of the disclosure are not limited to the following embodiments and may be embodied in various forms.

In the present specification, the terms such as "first," "second," etc. are used not in a restrictive sense but are used to distinguish one element from another.

The singular forms as used herein are intended to include the plural forms as well unless the context clearly indicates otherwise.

In the present specification, it will be understood that the terms "include" and/or "comprise" as used herein specify the presence of stated features or elements, but do not preclude the presence or addition of one or more other features or elements.

In the present specification, the expression "A and/or B" indicates only A, only B, or both A and B. In the present specification, the expression "at least one of A and B" indicates only A, only B, or both A and B.

In the present specification, it will be understood that, when an element such as a layer, film, region, or plate is referred to as being "on" another element, the element may be "directly on" the other element, and intervening elements may be present therebetween.

It will be further understood that when layers, regions, or elements are referred to as being connected to each other, they may be directly connected to each other or indirectly connected to each other with intervening layers, regions, or elements therebetween. For example, when layers, regions, or elements are referred to as being electrically connected to each other, they may be directly electrically connected to each other or indirectly electrically connected to each other with intervening layers, regions, or elements therebetween.

In the present specification, the x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

The term "in a plan view" as used herein means seeing a target portion from above. That is, in the present specification, the term "in a plan view" as used herein may mean "when viewed from a direction (z-axis direction) perpendicular to a major surface of a substrate."

"About" or "substantially the same" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, 5% or 2% of the stated value.

Hereinafter, embodiments will be described in detail with reference to the accompanying drawings. When describing embodiments with reference to the accompanying drawings, the same or corresponding elements are denoted by the same reference numerals, and redundant descriptions thereof will be omitted. For convenience of explanation, sizes of elements in the drawings may be exaggerated or reduced. For example, because sizes and thicknesses of elements in the drawings are arbitrarily illustrated for convenience of explanation, embodiments of the disclosure are not necessarily limited thereto.

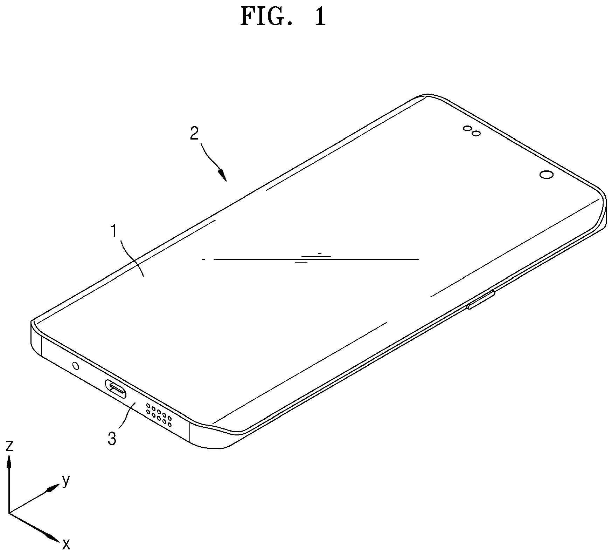

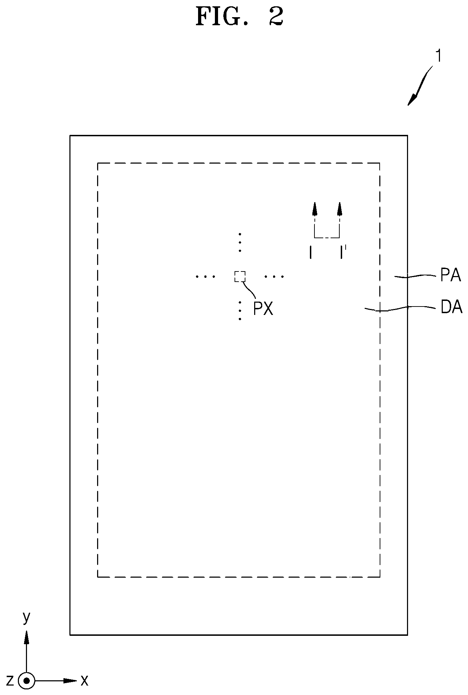

FIG. 1 is a schematic perspective view of an electronic device 2 according to an embodiment. FIG. 2 is a schematic plan view of a display apparatus 1 according to an embodiment.

As illustrated in FIGS. 1 and 2, the display apparatus 1 is an apparatus that displays moving images or still images. The display apparatus 1 may display a screen on the electronic device 2, or may input and output data to the electronic device 2.

Although FIG. 1 illustrates an embodiment in which the display apparatus 1 is used in a mobile phone, embodiments of the disclosure are not limited thereto. For another example, the display apparatus 1 may be used as display screens of portable electronic devices, such as mobile phones, smartphones, tablet personal computers ("PCs"), mobile communication terminals, electronic organizers, e-books, portable multimedia players ("PMPs"), navigation systems, and ultra mobile PCs ("UMPCs"). Also, the display apparatus 1 may be used as display screens of various products, such as televisions, laptops, monitors, billboards, and Internet of things ("IoT") devices.

In addition, the display apparatus 1 according to an embodiment may be used in electronic devices such as wearable devices, for example, smart watches, watch phones, glass-type displays, and head mounted displays ("HMDs"). In an embodiment, the display apparatus 1 may be used as displays of various electronic devices, for example, dashboards of automobiles, center information displays ("CIDs") on the center fascia or dashboards of automobiles, room mirror displays replacing side mirrors of automobiles, and displays on the rear sides of front seats to serve as entertainment devices for backseat passengers of automobiles.

In an embodiment, the display apparatus 1 may be accommodated in a housing 3 of the electronic device 2. The housing 3 may be a cover that protects internal components such as the display apparatus 1 and forms the exterior of the electronic device 2. In addition, the display apparatus 1 may be connected to an electronic module of the electronic device 2 and may be driven on the electronic device 2. The following description is given focusing on the display apparatus 1.

As illustrated in FIG. 2, the display apparatus 1 may include a display area DA in which a plurality of pixels PX are disposed and a peripheral area PA outside the display area DA. Specifically, the peripheral area PA may completely surround the display area DA.

The plurality of pixels PX of the display apparatus 1 are areas in which pieces of light of certain colors are emitted, and the display apparatus 1 may provide images by using the pieces of light emitted from the plurality of pixels PX. The plurality of pixels PX may externally emit, for example, red light, green light, or blue light. The display area DA may have a polygonal shape, such as a rectangular shape, as illustrated in FIG. 2. For example, the display area DA may have a rectangular shape in which a horizontal length is shorter than a vertical length, a rectangular shape in which a horizontal length is longer than a vertical length, or a square shape. Alternatively, the display area DA may have other shapes, such as an elliptical shape or a circular shape.

The peripheral area PA may be a non-display area in which the plurality of pixels PX are not disposed. A driver or the like configured to provide electrical signals or power to the plurality of pixels PX may be disposed in the peripheral area PA. A plurality of pads (not shown), which are areas to which an electronic element or a printed circuit board may be electrically connected, may be disposed in the peripheral area PA. The plurality of pads may be apart from each other in the peripheral area PA and may be electrically connected to a printed circuit board or integrated circuit devices.

Hereinafter, an organic light-emitting display apparatus is described as an example of the display apparatus 1 according to an embodiment, but the display apparatus 1 according to embodiments of the disclosure are not limited thereto. In another embodiment, examples of the display apparatus 1 according to the disclosure may include an inorganic light-emitting display (or an inorganic electroluminescence ("EL") display), a quantum dot light-emitting display, and/or the like. For example, an emission layer of a display element included in the display apparatus 1 may include an organic material or an inorganic material. Also, the display apparatus 1 may include an emission layer and quantum dots disposed on a path of light emitted from the emission layer.

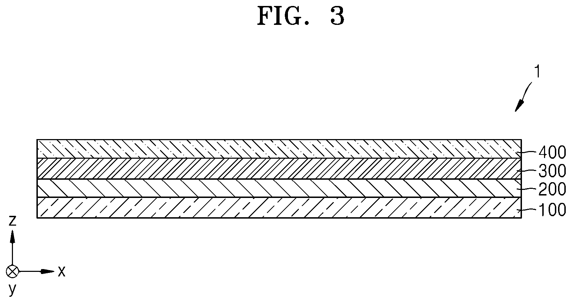

FIG. 3 is a schematic side view of a display apparatus 1 according to an embodiment. The display apparatus 1 may include a substrate 100, a display element layer 200, an encapsulation layer 300, and a touch sensor layer 400.

The substrate 100 may include glass, metal, or polymer resin. The substrate 100 may be flexible or bendable. In this case, the substrate 100 may include, for example, polymer resin, such as polyethersulfone, polyacrylate, polyetherimide, polyethylene naphthalate, polyethylene terephthalate, polyphenylene sulfide, polyarylate, polyimide, polycarbonate, or cellulose acetate propionate. Of course, various modifications are possible. For example, the substrate 100 may have a multilayer structure including two layers including polymer resin and a barrier layer including an inorganic material (e.g., silicon oxide (SiOₓ), silicon nitride (SiNₓ), silicon oxynitride (SiOₓN_{y}), etc.) between the two layers.

The display element layer 200 may be disposed on the substrate 100. The display element layer 200 may be a layer that includes a display element and displays an image. A plurality of display elements may be provided. That is, the display apparatus 1 may include a plurality of display elements, and the plurality of display elements may emit light. Accordingly, the display apparatus 1 may display an image through light emitted from the plurality of display elements.

Specifically, the display element layer 200 may include a display element and a pixel circuit electrically connected to the display element. In addition, the display element layer 200 may include scan lines, data lines, power lines, etc., which are connected to the pixel circuit, a scan driver configured to apply scan signals to the scan lines, fan-out lines connecting the data lines to the display driver, etc.

In an embodiment, the display element may be an organic light-emitting diode ("LED") including an organic emission layer. Alternatively, the display element may be an LED. The size of the light-emitting diode may be micro-scale or nano-scale. For example, the LED may be a micro-LED. Alternatively, the LED may be a nanorod LED. The nanorod LED may include gallium nitride (GaN). In an embodiment, a color conversion layer may be disposed on the nanorod LED. The color conversion layer may include quantum dots. Alternatively, the display element may be a quantum dot LED ("QLED") including a quantum dot emission layer. Alternatively, the display element may be an inorganic LED including an inorganic semiconductor.

The encapsulation layer 300 sealing the display element may be disposed on the display element layer 200. The encapsulation layer 300 may include at least one inorganic encapsulation layer and at least one organic encapsulation layer. Because the display element may be easily damaged by ambient moisture or oxygen, the encapsulation layer 300 may cover the display element so as to protect the display element.

The touch sensor layer 400 may be disposed on the encapsulation layer 300. The touch sensor layer 400 may be a layer configured to sense a touch input of a user. The touch sensor layer 400 may be configured to sense a touch input of a user by using, for example, a capacitive method. However, an operating method of the touch sensor layer 400 in the disclosure is not particularly limited. In an embodiment, the touch sensor layer 400 may be configured to sense external input by using an electromagnetic induction method or a pressure sensing method. The touch sensor layer 400 may include sensing electrodes so as to sense touch input.

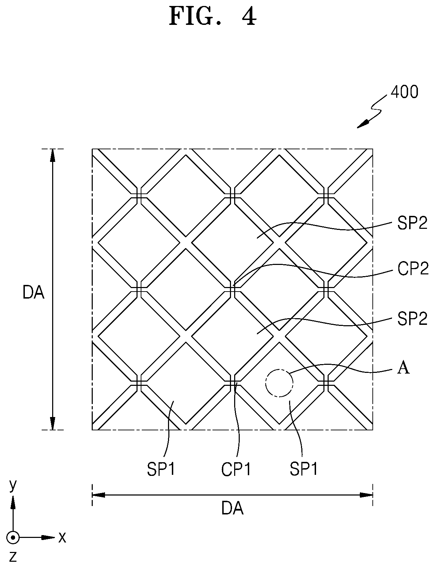

As illustrated in FIG. 4, which is a schematic plan view illustrating a portion of the touch sensor layer 400 of FIG. 3, the touch sensor layer 400 may include a plurality of first sensing electrodes SP1 disposed in a first direction (e.g., an x-axis direction) and a plurality of second sensing electrodes SP2 disposed in a second direction (e.g., a y-axis direction) crossing the first direction. The first direction and the second direction may cross perpendicularly. That is, FIG. 3 schematically illustrates the sensing electrodes included in the touch sensor layer 400.

The neighboring first sensing electrodes SP1 may be electrically connected to each other through a first connection electrode CP1. The neighboring second sensing electrodes SP2 may be electrically connected to each other through a second connection electrode CP2. The first sensing electrodes SP1 and the second sensing electrodes SP2 may each include a conductive layer, and the conductive layer may include a conductive material. For example, the conductive layer may include molybdenum (Mo), aluminum (Al), copper (Cu), or titanium (Ti), and may have a single-layer or multilayer structure including the material described above. For example, the conductive layer may have a structure in which a titanium layer, an aluminum layer, and a titanium layer (Ti/Al/Ti) are sequentially stacked in this stated order. Each of the first connection electrode CP1 and the second connection electrode CP2 may also include a conductive layer as described above.

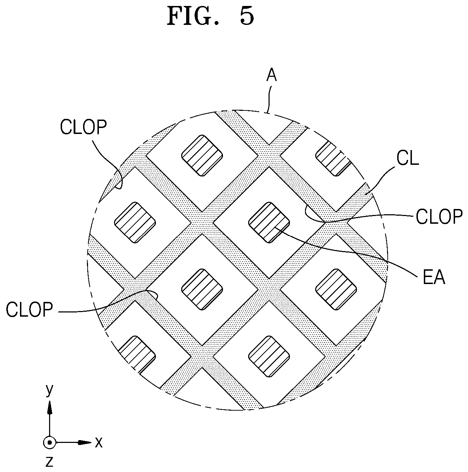

The sensing electrodes and the connection electrodes may each have a mesh structure defining a plurality of openings therein. For example, as illustrated in FIG. 5, which is an enlarged plan view of a region A of FIG. 4, the first sensing electrodes SP1 may each be disposed on a touch conductive layer CL. The touch conductive layer CL may define each of a plurality of conductive layer openings CLOP. That is, a body portion of the touch conductive layer CL may surround each of the conductive layer openings CLOP. Accordingly, the touch conductive layer CL may form a mesh structure. In other words, the first sensing electrode SP1 may have a mesh structure including a plurality of openings. Similarly, each of the second sensing electrodes SP2, each of the first connection electrodes CP1, and each of the second connection electrodes CP2 may also have a mesh structure. Each of the conductive layer openings CLOP of the touch conductive layer CL may overlap an emission area EA of each of the display elements.

In an embodiment, in FIG. 5, the emission area EA of the display element is illustrated as having a rhombus shape in a plan view, but embodiments of the disclosure are not limited thereto. In a plan view, the emission area EA of the display element may have a polygonal shape, such as a triangular shape or a rectangular shape. Alternatively, in a plan view, the emission area EA of the display element may have various shapes, such as an elliptical shape or a circular shape.

Although FIG. 5 illustrates that the conductive layer openings CLOP are completely surrounded by the body portion of the touch conductive layer CL and are not spatially connected to each other, embodiments of the disclosure are not limited thereto. For another example, at least one of the plurality of conductive layer openings CLOP may be partially surrounded by the body portion of the touch conductive layer CL. In this case, the neighboring conductive layer openings CLOP may be spatially connected to each other.

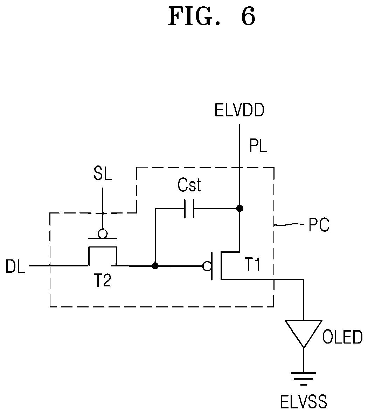

FIG. 6 is an equivalent circuit diagram of a pixel circuit PC included in the display apparatus 1 of FIG. 2. The pixel circuit PC may be electrically connected to a display element. One display element may correspond to one pixel. In FIG. 6, an organic LED OLED is illustrated as the display element. In an embodiment, the display element may emit red light, green light, or blue light.

The pixel circuit PC may include a first transistor T1, a second transistor T2, and a storage capacitor Cst. The second transistor T2, which acts as a switching transistor, may be connected to a scan line SL and a data line DL and may be configured to be turned on in response to a switching signal input from the scan line SL and transmit, to the first transistor T1, a data signal input from the data line DL. The storage capacitor Cst may have one end electrically connected to the second transistor T2 and the other end electrically connected to a driving voltage line PL and may be configured to store a voltage corresponding to a difference between a voltage received from the second transistor T2 and a driving power supply voltage ELVDD supplied to the driving voltage line PL.

The first transistor T1, which acts as a driving transistor, may be connected to the driving voltage line PL and the storage capacitor Cst and may be configured to control an amount of a driving current flowing from the driving voltage line PL to the organic LED OLED according to a voltage value stored in the storage capacitor Cst. The organic LED OLED may be configured to emit light with a certain luminance according to the driving current. An opposite electrode of the organic LED OLED may be configured to receive an electrode power supply voltage ELVSS.

Although FIG. 6 illustrates that the pixel circuit PC includes two transistors and one storage capacitor, embodiments of the disclosure are not limited thereto. For another example, the number of transistors or the number of storage capacitors may be variously changed according to the design of the pixel circuit PC.

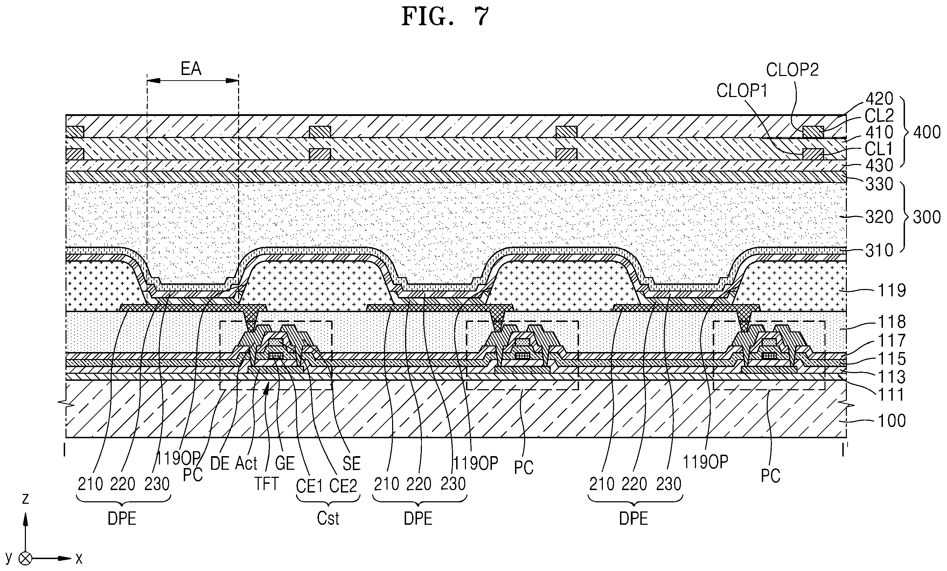

FIG. 7 is a schematic cross-sectional view of the display apparatus 1 of FIG. 2 taken along line I-I' of FIG. 2. Of course, as recognized by those of ordinary skill in the art, the display apparatus 1 may further include, in addition to the components illustrated in FIG. 7, various other components.

As illustrated in FIG. 7, the display apparatus 1 may include a substrate 100. Because the display panel 10 includes the substrate 100, it may be stated that the substrate 100 has a display area DA and a peripheral area PA. For convenience, it is assumed that the substrate 100 has the display area DA and the peripheral area PA.

A display element DPE and a pixel circuit PC to which the display element DPE is electrically connected may be disposed in the display area DA of the substrate 100. The expression "the display element DPE is electrically connected to the pixel circuit PC" may be understood as meaning that a pixel electrode 210 included in the display element DPE is electrically connected to a transistor TFT of a pixel circuit PC.

The display element DPE and the pixel circuit PC electrically connected to the display element DPE may be disposed on the substrate 100. Specifically, a plurality of pixel circuits PC may be disposed on the substrate 100. The plurality of pixel circuits PC may be electrically connected to the plurality of display elements DPE, respectively. Because the plurality of pixel circuits PC have the same structure and the plurality of display elements DPE have the same structure, the following description is given focusing on one pixel circuit PC and one display element DPE.

The pixel circuit PC may be disposed on the substrate 100. The pixel circuit PC may include a plurality of transistors TFT and a storage capacitor Cst. For convenience of illustration, one transistor TFT is illustrated in FIG. 7, and the transistor TFT may correspond to the first transistor (see T1 of FIG. 6) described above.

A buffer layer 111 may be disposed between the transistor TFT and the substrate 100. The buffer layer 111 may include an inorganic material, such as silicon oxide (SiOx), silicon nitride (SiNx), and/or silicon oxynitride (SiO_{X}N_{Y}). The buffer layer 111 may increase the smoothness of the upper surface of the substrate 100, or may prevent or minimize infiltration of impurities from the substrate 100 or the like into a semiconductor layer Act of the transistor TFT.

As illustrated in FIG. 7, the transistor TFT may include the semiconductor layer Act including amorphous silicon, polycrystalline silicon, an organic semiconductor material, or an oxide semiconductor material. The transistor TFT may include a gate electrode GE, a source electrode SE, and/or a drain electrode DE. The gate electrode GE may include various conductive materials and have various layered structures. For example, the gate electrode GE may include a Mo layer and an Al layer. Alternatively, the gate electrode GE may include a TiNx layer, an Al layer, and/or a Ti layer. Each of the source electrode SE and the drain electrode DE may also include various conductive materials and have various layered structures. For example, each of the source electrode SE and the drain electrode DE may include a Ti layer, an Al layer, and/or a Cu layer.

In order to ensure electrical insulation between the semiconductor layer Act and the gate electrode GE, a gate insulating layer 113 may be disposed between the semiconductor layer Act and the gate electrode GE. The gate insulating layer 113 may include an inorganic material, such as silicon oxide (SiOx), silicon nitride, (SiNx), and/or silicon oxynitride (SiO_{X}N_{Y}). Although FIG. 7 illustrates that the gate insulating layer 113 has a shape corresponding to the entire surface of the substrate 100 and has a structure in which contact holes are defined in preset portions, the disclosure is not limited thereto. For another example, the gate insulating layer 113 may be patterned to have the same shape as the gate electrode GE.

In addition, a first interlayer-insulating layer 115 may be disposed on the gate electrode GE. The first interlayer-insulating layer 115 may include an inorganic insulating material, such as silicon oxide (SiOx), silicon nitride (SiNx), and/or silicon oxynitride (SiO_{X}N_{Y}). The first interlayer-insulating layer 115 may have a single-layer or multilayer structure including the material described above. The gate insulating layer 113 and the first interlayer-insulating layer 115 each including the inorganic insulating material may be formed by chemical vapor deposition or the like. The same applies to embodiments and modifications to be described below.

The storage capacitor Cst may include a first capacitor electrode CE1 and a second capacitor electrode CE2 that overlap each other with the first interlayer-insulating layer 115 therebetween in a plan view. The storage capacitor Cst may overlap the transistor TFT. In this regard, FIG. 7 illustrates that the gate electrode GE of the transistor TFT is the first capacitor electrode CE1 of the storage capacitor Cst, but embodiments of the disclosure are not limited thereto. For another example, the storage capacitor Cst may not overlap the transistor TFT in a plan view. The second capacitor electrode CE2 of the storage capacitor Cst may include a conductive material including molybdenum (Mo), aluminum (Al), copper (Cu), or titanium (Ti) and may include a single layer or layers including the conductive material described above.

A second interlayer-insulating layer 117 may be disposed on the second capacitor electrode CE2 of the storage capacitor Cst. The second interlayer-insulating layer 117 may include an inorganic material, such as silicon oxide (SiOx), silicon nitride (SiNx), and/or silicon oxynitride (SiO_{X}N_{Y}). The second interlayer-insulating layer 117 may have a single-layer or multilayer structure including the inorganic material described above.

The source electrode SE and the drain electrode DE may be disposed on the second interlayer-insulating layer 117. Each of the source electrode SE and the drain electrode DE may include a material having excellent conductivity. Each of the source electrode SE and the drain electrode DE may include a conductive material including molybdenum (Mo), aluminum (Al), copper (Cu) or titanium (Ti) and may include a single-layer or multilayer structure including the conductive material described above. For example, each of the source electrode SE and the drain electrode DE may have a multilayer structure of Ti/Al/Ti.

Of course, embodiments of the disclosure are not limited thereto. For another example, the transistor TFT may include only one of the source electrode SE and the drain electrode DE, or may not include both of the source electrode SE and the drain electrode DE. For example, one transistor TFT may not include the drain electrode DE, another transistor TFT connected to the transistor TFT may not include the source electrode SE, and the semiconductor layers Act of the two transistors may be connected to each other. Such a connection structure may have the same effect as a case where one transistor TFT also includes the source electrode SE, another transistor TFT also includes the drain electrode DE, and the source electrode SE of the one transistor TFT is connected to the drain electrode DE of the other transistor TFT.

As illustrated in FIG. 7, an organic insulating layer 118 may be disposed to cover the transistor TFT and the storage capacitor Cst. The organic insulating layer 118 may include an organic insulating material. For example, the organic insulating layer 118 may include photoresist, benzocyclobutene ("BCB"), polyimide, hexamethyldisiloxane ("HMDSO"), polymethylmethacrylate ("PMMA"), polystyrene, polymer derivatives having a phenolic group, acrylic polymer, imide-based polymer, aryl ether-based polymer, amide-based polymer, fluorine-based polymer, p-xylene-based polymer, vinyl alcohol-based polymer, or any mixture thereof. Although not illustrated in FIG. 7, a third interlayer-insulating layer (not shown) may be further disposed below the organic insulating layer 118. The third interlayer-insulating layer may include an inorganic insulating material, such as silicon oxide (SiOx), silicon nitride (SiNx), and/or silicon oxynitride (SiOxNy).

The display element DPE may be disposed on the organic insulating layer 118. For example, the display element DPE may be an organic LED. The display element DPE may include a pixel electrode 210, an emission layer 220, and an opposite electrode 230. The opposite electrode 230 may be integrally provided across the entire surface of the display apparatus 1, and thus, may be commonly provided for a plurality of display elements DPE.

The pixel electrode 210 may include a transmissive conductive layer including a transmissive conductive oxide, such as indium tin oxide ("ITO"), In₂O₃, or indium zinc oxide ("IZO"), and a reflective layer including metal, such as Al or Ag. For example, the pixel electrode 210 may have a three-layer structure of ITO/Ag/ITO. As illustrated in FIG. 7, the pixel electrode 210 may be electrically connected to the transistor TFT by coming into contact with one of the source electrode SE or the drain electrode DE. Specifically, the pixel electrode 210 may come into contact with one of the source electrode SE or the drain electrode DE through a contact hole defined in the organic insulating layer 118.

A pixel defining layer 119 may be disposed on the organic insulating layer 118. As described above, the pixel defining layer 119 may define a pixel opening 119OP therein. The pixel opening 119OP may expose the central portion of the pixel electrode 210 of the display element DPE, and at least a portion of the emission layer 220 of the display element DPE may be disposed within the pixel opening 119OP. That is, an emission area EA of the display element DPE may be defined by the pixel opening 119OP. In addition, in the case illustrated in FIG. 7, the pixel defining layer 119 may increase the distance between the edge of the pixel electrode 210 and the opposite electrode 230 on the pixel electrode 210. Due to this, an electric arc or the like may be prevented from occurring at the edge of the pixel electrode 210. The pixel defining layer 119 may include, for example, an organic material, such as polyimide or HMDSO.

The opposite electrode 230 may be disposed on the pixel electrode 210. The opposite electrode 230 may be provided integrally across the plurality of display elements DPE. Accordingly, the opposite electrode 230 may be disposed on the plurality of pixel electrodes 210. The opposite electrode 230 may include a transmissive conductive layer including ITO, In₂O₃, or IZO, and may also include a semi-transmissive layer including metal, such as Al or Ag. For example, the opposite electrode 230 may be a semi-transmissive layer including Mg or Ag.

The emission layer 220 configured to emit light may be disposed between the pixel electrode 210 and the opposite electrode 230. The emission layer 220 may be configured to emit red light, green light, or blue light. The emission layer 220 may include a high molecular weight organic material or a low molecular weight organic material that emits certain color light (red light, green light, or blue light). For example, the emission layer 220 may include a polymer material, such as polyphenylenevinylene ("PPV") and polyfluorene. The emission layer 220 may be formed by screen printing, inkjet printing, laser induced thermal imaging ("LITI"), or the like. However, embodiments of the disclosure are not limited thereto.

In an embodiment, functional layers (not shown) may be disposed below and above the emission layer 220. The functional layers may include a hole injection layer ("HIL"), a hole transport layer ("HTL"), an electron transport layer ("ETL"), and/or an electron injection layer ("EIL"). The functional layers may be integral across the plurality of pixel electrodes 210, or may be patterned to correspond to the plurality of pixel electrodes 210, respectively.

An encapsulation layer 300 may be disposed on the display element DPE. Specifically, the encapsulation layer 300 may be disposed on the opposite electrode 230. That is, because the display element DPE may be easily damaged by ambient moisture or oxygen, the encapsulation layer 300 may cover the display element DPE so as to protect the display element DPE. As illustrated in FIG. 7, the encapsulation layer 300 may include a first inorganic encapsulation layer 310, an organic encapsulation layer 320, and a second inorganic encapsulation layer 330. Specifically, the encapsulation layer 300 including the first inorganic encapsulation layer 310, the second inorganic encapsulation layer 330, and the organic encapsulation layer 320 therebetween may be disposed on the opposite electrode 230.

The first inorganic encapsulation layer 310 may cover the opposite electrode 230 and may include at least one of silicon oxide (SiOx), silicon nitride (SiNx), or silicon oxynitride (SiO_{X}N_{Y}). Of course, other layers, such as a capping layer, may be disposed between the first inorganic encapsulation layer 310 and the opposite electrode 230 in an embodiment. Because the first inorganic encapsulation layer 310 is formed along the underlying structure, the upper surface of the first inorganic encapsulation layer 310 may not be flat, as illustrated in FIG. 7.

The organic encapsulation layer 320 may cover the first inorganic encapsulation layer 310. The organic encapsulation layer 320 may be disposed on the first inorganic encapsulation layer 310. In other words, the organic encapsulation layer 320 may be disposed between the first inorganic encapsulation layer 310 and the second inorganic encapsulation layer 330. Unlike the first inorganic encapsulation layer 310, the upper surface of the organic encapsulation layer 320 may be substantially flat. The organic encapsulation layer 320 may include at least one material selected from polyethylene terephthalate, polyethylene naphthalate, polycarbonate, polyimide, polyethylene sulfonate, polyoxymethylene, polyarylate, and hexamethyldisiloxane.

The second inorganic encapsulation layer 330 may cover the organic encapsulation layer 320. The second inorganic encapsulation layer 330 may be disposed on the organic encapsulation layer 320 and the second inorganic encapsulation layer 330 may be in direct contact with the organic encapsulation layer 320. The second inorganic encapsulation layer 330 may include at least one of silicon nitride (SiNx) or silicon oxynitride (SiO_{X}N_{Y}). The organic encapsulation layer 320 and the second inorganic encapsulation layer 330 are described in detail below.

The encapsulation layer 300 includes the first inorganic encapsulation layer 310, the organic encapsulation layer 320, and the second inorganic encapsulation layer 330, and thus, even when cracks occur within the encapsulation layer 300 through the multilayer structure, such cracks may be prevented from being connected to each other between the first inorganic encapsulation layer 310 and the organic encapsulation layer 320 or between the organic encapsulation layer 320 and the second inorganic encapsulation layer 330. This may effectively prevent or minimize the formation of a path through which ambient moisture or oxygen penetrates into the display apparatus 1.

In an embodiment, a touch sensor layer 400 may be disposed on the encapsulation layer 300. The touch sensor layer 400 may include a touch conductive layer and a touch insulating layer covering the touch conductive layer. Specifically, the touch sensor layer 400 may include a first touch conductive layer CL1, a first touch insulating layer 410, a second touch conductive layer CL2, and a second touch insulating layer 420.

The first touch conductive layer CL1 may be disposed on the second inorganic encapsulation layer 330. In an embodiment, the first touch conductive layer CL1 may overlap the pixel defining layer 119 in a plan view. The first touch conductive layer CL1 may not overlap the pixel opening 119OP of the pixel defining layer 119 in a plan view. That is, the first touch conductive layer CL1 may define a first conductive layer opening CLOP1 that overlaps the emission area EA of the display element DPE. Accordingly, the first touch conductive layer CL1 may have a mesh structure to allow light emitted from the display element DPE to pass therethrough.

The first touch conductive layer CL1 may include a conductive material. For example, the first touch conductive layer CL1 may include molybdenum (Mo), aluminum (Al), copper (Cu), or titanium (Ti), and may have a single-layer or multilayer structure including the material described above. For example, the first touch conductive layer CL1 may have a structure in which a titanium layer, an aluminum layer, and a titanium layer (Ti/Al/Ti) are sequentially stacked in this stated order.

The first touch insulating layer 410 may cover the first touch conductive layer CL1. That is, the first touch insulating layer 410 may be a touch insulating layer covering the touch conductive layer. The first touch insulating layer 410 may have a single-layer or multilayer structure including an inorganic insulating material, such as silicon oxide (SiOx), silicon nitride (SiNx), and/or silicon oxynitride (SiO_{X}N_{Y}). In some embodiments, the first touch insulating layer 410 may include an organic insulating material.

The second touch conductive layer CL2 may be disposed on the first touch insulating layer 410. In an embodiment, the second touch conductive layer CL2 may overlap the pixel defining layer 119 in a plan view. The second touch conductive layer CL2 may not overlap the pixel opening 119OP of the pixel defining layer 119 in a plan view. That is, the second touch conductive layer CL2 may define a second conductive layer opening CLOP2 that overlaps the emission area EA of the display element DPE in a plan view. Accordingly, the second touch conductive layer CL2 may have a mesh structure to allow light emitted from the display element DPE to pass therethrough.

The second touch conductive layer CL2 may include a conductive material. For example, the second touch conductive layer CL2 may include molybdenum (Mo), aluminum (Al), copper (Cu), or titanium (Ti), and may have a single-layer or multilayer structure including the material described above. For example, the second touch conductive layer CL2 may have a structure in which a titanium layer, an aluminum layer, and a titanium layer (Ti/Al/Ti) are sequentially stacked in this stated order.

In an embodiment, the second touch conductive layer CL2 may be electrically connected to the first touch conductive layer CL1 through a contact hole defined in the first touch insulating layer 410. Each of the first sensing electrode SP1 and the second sensing electrode SP2, which has been described with reference to FIG. 4, may be disposed in a two-layer structure of the first touch conductive layer CL1 and the second touch conductive layer CL2, which are electrically connected to each other. In other words, the touch conductive layer CL of FIG. 5 may include the first touch conductive layer CL1 and the second touch conductive layer CL2, and the conductive layer opening CLOP of FIG. 5 may include the first conductive layer opening CLOP1 and the second conductive layer opening CLOP2.

The second touch insulating layer 420 may cover the second touch conductive layer CL2. That is, the second touch insulating layer 420 may be a touch insulating layer covering the touch conductive layer. The second touch insulating layer 420 may have a single-layer or multilayer structure including an inorganic insulating material, such as silicon oxide (SiOx), silicon nitride (SiNx), and/or silicon oxynitride (SiO_{X}N_{Y}). In some embodiments, the second touch insulating layer 420 may include an organic insulating material.

In an embodiment, the touch sensor layer 400 may further include a touch buffer layer 430. The touch buffer layer 430 may be disposed between the encapsulation layer 300 and the first touch conductive layer CL1. Specifically, the touch buffer layer 430 may be disposed on the second inorganic encapsulation layer 330 and the first touch conductive layer CL1 may be disposed on the touch buffer layer 430. The touch buffer layer 430 may prevent damage to the encapsulation layer 300 and may block interference signals that may occur when the touch sensor layer 400 is driven. In an embodiment, the touch buffer layer 430 may have a single-layer or multilayer structure including an inorganic insulating material, such as silicon oxide (SiOx), silicon nitride (SiNx), and/or silicon oxynitride (SiO_{X}N_{Y}). In some embodiments, the touch buffer layer 430 may include an organic insulating material.

In an embodiment, as illustrated in FIG. 7, the touch sensor layer 400 may overlap the opposite electrode 230 in a plan view, and the encapsulation layer 300 may be disposed between the touch sensor layer 400 and the opposite electrode 230. Specifically, the organic encapsulation layer 320 may be disposed between the touch sensor layer 400 and the opposite electrode 230. In this case, a capacitance may be formed by the touch sensor layer 400 and the opposite electrode 230. The capacitance formed by the touch sensor layer 400 and the opposite electrode 230 may reduce the sensing sensitivity (or touch sensitivity) of the touch sensor layer 400.

The performance degradation of the touch sensor layer 400 may vary depending on the organic encapsulation layer 320 between the touch sensor layer 400 and the opposite electrode 230. Specifically, in a case where the organic encapsulation layer 320 has a low relative permittivity, the performance of the touch sensor layer 400 may be less degraded, compared to a case where the organic encapsulation layer 320 has a high relative permittivity. The relative permittivity is a numerical value indicating a relative ratio of a permittivity of a material to vacuum permittivity, and the permittivity is a physical property indicating the magnitude of the polarization that a dielectric produces in response to an external electric field.

To this end, the organic encapsulation layer 320 may have a low relative permittivity. For example, the organic encapsulation layer 320 may have a relative permittivity of 2.3 to 2.7. As described above, the organic encapsulation layer 320 may include a material that does not contain fluorine. In general, a non-fluorinated polymer that does not contain fluorine has a relative permittivity of 2.3 or more. Therefore, the organic encapsulation layer 320 may have a relative permittivity of 2.3 or more. However, when the relative permittivity of the organic encapsulation layer 320 is greater than 2.7, the performance of the touch sensor layer 400 may be significantly reduced.

The relative permittivity of the organic encapsulation layer 320 may vary depending on the content ratio of materials forming the organic encapsulation layer 320. Specifically, the organic encapsulation layer 320 may be a material obtained by curing an organic encapsulation layer forming material. The organic encapsulation layer forming material may include a first monomer including at least one of a substituted or unsubstituted aliphatic ring group and a substituted or unsubstituted aromatic ring group, and a second monomer not including a substituted or unsubstituted aliphatic ring group and a substituted or unsubstituted aromatic ring group. For example, the first monomer may include a monomer represented by Formula 1 below:

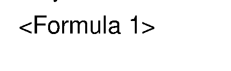

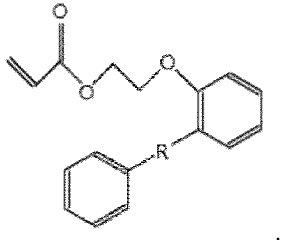

In Formula 1, R may be a substituted or unsubstituted C1-C30 alkylene group, a substituted or unsubstituted C6-C30 cycloalkylene group, a substituted or unsubstituted C6-C30 arylene group, or a substituted or unsubstituted C6-C30 heteroarylene group. However, embodiments of the disclosure are not limited thereto.

That is, the organic encapsulation layer 320 may be formed by applying the organic encapsulation layer forming material onto the first inorganic encapsulation layer 310 by using an inkjet or the like and then performing photocuring thereon. The first monomer may be included in the organic encapsulation layer forming material in an amount of about 10 weight percentages (wt%) to about 30 wt%. In the present specification, the content of each component included in the organic encapsulation layer forming material may be based on the total weight of the organic encapsulation layer forming material and may be a result of analysis using nuclear magnetic resonance ("NMR") spectroscopy. The NMR is a method of measuring a sample to be analyzed by using radio frequency ("RF") resonance that causes rotational transitions in atomic nuclei.

When the material constituting the organic encapsulation layer 320 includes a substituted or unsubstituted aliphatic ring group or a substituted or unsubstituted aromatic ring group, the polarity within the material constituting the organic encapsulation layer 320 may increase, and thus, the relative permittivity of the organic encapsulation layer 320 may not be low. When the first monomer is included in the organic encapsulation layer forming material in an amount of greater than 30 wt%, the relative permittivity of the organic encapsulation layer 320 may be high. Accordingly, the first monomer may be included in the organic encapsulation layer forming material in an amount of less than 30 wt%.

In an embodiment, plasma is used to form the second inorganic encapsulation layer 330 on the organic encapsulation layer 320. Due to the plasma, outgas may be generated from the organic encapsulation layer 320. The first inorganic encapsulation layer 310 under the organic encapsulation layer 320 may be formed by chemical vapor deposition or the like. When the first inorganic encapsulation layer 310 is formed by chemical vapor deposition, cracks may exist on the surface of the first inorganic encapsulation layer 310. Accordingly, outgas generated from the organic encapsulation layer 320 may penetrate toward the display element DPE through the cracks of the first inorganic encapsulation layer 310. Outgas that has penetrated toward the display element DPE may oxidize the opposite electrode 230 of the display element DPE, which causes dark spots on the display apparatus 1.

When the material constituting the organic encapsulation layer 320 includes a plurality of substituted or unsubstituted aliphatic ring groups or a plurality of substituted or unsubstituted aromatic ring groups, outgas may not be generated from the organic encapsulation layer 320 by the plasma, or the amount of outgas generated may be reduced. On the other hand, when the material constituting the organic encapsulation layer 320 includes a small amount of substituted or unsubstituted aliphatic ring groups or substituted or unsubstituted aromatic ring groups, a large amount of outgas may be generated from the organic encapsulation layer 320 by the plasma. Specifically, when the first monomer is included in the organic encapsulation layer 320 forming material in an amount of less than 10 wt%, dark spots may occur on the display apparatus 1 due to the outgas generated from the organic encapsulation layer 320. Accordingly, the first monomer may be included in the organic encapsulation layer forming material in an amount of 10 wt% or more. Therefore, in an embodiment, the first monomer may be included in the organic encapsulation layer 320 forming material in an amount of about 10 wt% to about 30 wt%.

The second monomer may be included in the organic encapsulation layer 320 forming material in an amount of about 70 wt% to about 90 wt%. In an embodiment, the organic encapsulation layer 320 forming material may further include a photocuring agent. The photocuring agent may be any agent that is usable to photocure a monomer and/or polymer for forming the organic encapsulation layer 320 and is not particularly limited.

In this case, the organic encapsulation layer 320 may have a low modulus. Specifically, the organic encapsulation layer 320 may have a modulus of greater than 60 MPa and less than 1 GPa. The modulus of the organic encapsulation layer 320 in the present specification was measured at room temperature. When the organic encapsulation layer 320 has a low relative permittivity, the material forming the organic encapsulation layer 320 may have a low crosslinking density. Due to the low crosslinking density, the modulus of the organic encapsulation layer 320 may be low. Specifically, the modulus of the organic encapsulation layer 320 may be less than 1 GPa.

However, when the modulus of the organic encapsulation layer 320 is excessively low, the organic encapsulation layer 320 may be detached from the second inorganic encapsulation layer 330, or wrinkles may occur in the organic encapsulation layer 320. Specifically, when the modulus of the organic encapsulation layer 320 is 60 MPa or less, the organic encapsulation layer 320 may be detached from the second inorganic encapsulation layer 330, or wrinkles may occur in the organic encapsulation layer 320. Accordingly, the modulus of the organic encapsulation layer 320 may be greater than 60 MPa. That is, the organic encapsulation layer 320 may have a modulus of greater than 60 MPa and less than 1 GPa.

The second inorganic encapsulation layer 330 that is in direct contact with the organic encapsulation layer 320 may have a low density. The density of the second inorganic encapsulation layer 330 may be measured by using X-ray photoelectron spectroscope ("XPS") or the like. Specifically, the second inorganic encapsulation layer 330 may have a density of greater than about 1.8 gram per cubic centimeters (g/cm³) and less than about 2.03 g/cm³. As the density of the second inorganic encapsulation layer 330 decreases, residual stress of the second inorganic encapsulation layer 330 may also decrease. Specifically, the second inorganic encapsulation layer 330 in an embodiment may have a compressive stress of greater than 60 MPa and less than 180 MPa.

In general, when a metal layer is formed by sputtering or the like, the formed metal layer may have residual stress. The residual stress is an inherent characteristic of the metal layer and does not change even when an external force is applied to the metal layer. The metal layer may have tensile stress or compressive stress as the residual stress. On the other hand, an inorganic insulating layer formed by chemical vapor deposition or the like may also have residual stress. The inorganic insulating layer may have compressive stress as the residual stress. Accordingly, the second inorganic encapsulation layer 330 in an embodiment may have residual stress.

Specifically, as the density of the second inorganic encapsulation layer 330 increases, the residual stress of the second inorganic encapsulation layer 330 may become more compressive. For example, when the second inorganic encapsulation layer 330 has a density of 1.8 g/cm³, the second inorganic encapsulation layer 330 may have a compressive stress of about 60 MPa. When the second inorganic encapsulation layer 330 has a density of 2.03 g/cm³, the second inorganic encapsulation layer 330 may have a compressive stress of about 180 MPa.

When the second inorganic encapsulation layer 330 has a density of about 2.03 g/cm³ or more and the second inorganic encapsulation layer 330 has a compressive stress of about 180 MPa or more, the organic encapsulation layer 320 may be detached from the second inorganic encapsulation layer 330, or wrinkles may occur in the organic encapsulation layer 320. Specifically, when the second inorganic encapsulation layer 330 has a density of about 2.03 g/cm³ or more and the second inorganic encapsulation layer 330 has a compressive stress of about 180 MPa or more, the compressive stress of the second inorganic encapsulation layer 330 may be excessively great, compared to the organic encapsulation layer 320 having a compressive stress of several tens to several hundred Pa. Accordingly, the organic encapsulation layer 320 may be detached from the second inorganic encapsulation layer 330, or wrinkles may occur in the organic encapsulation layer 320. Accordingly, the second inorganic encapsulation layer 330 in an embodiment may have a density of less than 2.03 g/cm³ and a compressive stress of less than 180 MPa.

However, when the second inorganic encapsulation layer 330 has a density of 1.8 g/cm³ or less and a compressive stress of 60 MPa or less, the second inorganic encapsulation layer 330 may not be sufficient to protect the display element DPE from ambient moisture or oxygen. Accordingly, dark spots may occur on the display apparatus 1 due to ambient moisture or oxygen. Accordingly, the second inorganic encapsulation layer 330 may have a density of greater than 1.8 g/cm³ and a compressive stress of greater than 60 MPa. Accordingly, the second inorganic encapsulation layer 330 may have a density of greater than 1.8 g/cm³ and less than 2.03 g/cm³ and a compressive stress of greater than 60 MPa and less than 180 MPa. Accordingly, the possibility of defects occurring during a process of manufacturing the display apparatus 1 may be effectively reduced.

The density and residual stress of the inorganic insulating layer may be controlled by various factors, such as energy of the material forming the inorganic insulating layer during deposition, pressure during deposition, or voltages applied to the substrate during deposition, when forming the inorganic insulating layer by using chemical vapor deposition or the like. For example, as the energy of the material forming the inorganic insulating layer during deposition increases, the density and residual stress of the inorganic insulating layer may increase. Because it is apparent to those of ordinary skill in the art to control the density and residual stress of the second inorganic encapsulation layer 330, which is the inorganic insulating layer, by using the factors described above, a detailed description thereof is omitted.

In this case, the oxidation rate of the second inorganic encapsulation layer 330 may be high. The oxidation rate of the second inorganic encapsulation layer 330 in the present specification was measured by exposing the second inorganic encapsulation layer 330 to a temperature of 85 °C and a humidity of 85 % for 504 hours after the second inorganic encapsulation layer 330 was made as the outermost layer of the display apparatus 1. For example, by removing the layers disposed on the second inorganic encapsulation layer 330 through milling or the like, the second inorganic encapsulation layer 330 may be made as the outermost layer of the display apparatus 1. Because it is apparent to those of ordinary skill in the art that the second inorganic encapsulation layer 330 is made as the outermost layer of the display apparatus 1 by using the method described above, a detailed description thereof is omitted.

Specifically, the oxidation rate of the second inorganic encapsulation layer 330 may be greater than 0.7 Å/h and less than 2.3 Å/h. As described above, the second inorganic encapsulation layer 330 may include at least one of silicon nitride (SiNx) or silicon oxynitride (SiO_{X}N_{Y}). At a temperature of 85 °C and a humidity of 85 %, silicon nitride (SiNx) or the like of the second inorganic encapsulation layer 330 may be changed to silicon oxide (SiOx). At a temperature of 85 °C and a humidity of 85 %, silicon nitride (SiNx) or the like of the second inorganic encapsulation layer 330 may be oxidized. This change may start from one surface of the second inorganic encapsulation layer 330 in a direction opposite to the substrate 100 and progress toward the substrate 100. Therefore, the oxidation rate of the second inorganic encapsulation layer 330 in the present specification was measured by measuring the thickness of the second inorganic encapsulation layer 330 in which such a change has occurred.

Specifically, the expression "the oxidation rate of the second inorganic encapsulation layer 330 is 0.7 Å/h" means that silicon nitride (SiNx) of the second inorganic encapsulation layer 330 was changed to silicon oxide (SiOx) by a thickness of about 352.8 angstroms (Å) at a temperature of 85 °C and a humidity of 85 % for 504 hours. Of course, the expression "the oxidation rate of the second inorganic encapsulation layer 330 is 2.3 Å/h" means that silicon nitride (SiNx) of the second inorganic encapsulation layer 330 was changed to silicon oxide (SiOx) by a thickness of about 1159.2 Å at a temperature of 85 °C and a humidity of 85 % for 504 hours. An oxidized portion of the second inorganic encapsulation layer 330 in which silicon nitride (SiNx) or the like was changed to silicon oxide (SiOx) is different from a non-oxidized portion of the second inorganic encapsulation layer 330 in which silicon nitride (SiNx) or the like was not changed to silicon oxide (SiOx) in terms of the contents of oxygen and nitrogen. Accordingly, an interface between the oxidized portion of the second inorganic encapsulation layer 330 and the non-oxidized portion of the second inorganic encapsulation layer 330 may be identified on the cross-section of the second inorganic encapsulation layer 330.

When the oxidation rate of the second inorganic encapsulation layer 330 is 0.7 Å/h or less, the second inorganic encapsulation layer 330 may have a density of 2.03 g/cm³ or more and a compressive stress of 180 MPa or more. Accordingly, the organic encapsulation layer 320 may be detached from the second inorganic encapsulation layer 330, or wrinkles may occur in the organic encapsulation layer 320. Therefore, the oxidation rate of the second inorganic encapsulation layer 330 may be greater than 0.7 Å/h.

However, when the oxidation rate of the second inorganic encapsulation layer 330 is 2.3 Å/h or more, the second inorganic encapsulation layer 330 may have a density of 1.8 g/cm³ or less and a compressive stress of 60 MPa or less. Accordingly, dark spots may occur on the display apparatus 1 due to ambient moisture or oxygen. Therefore, the oxidation rate of the second inorganic encapsulation layer 330 in an embodiment may be less than 2.3 Å/h. That is, when the second inorganic encapsulation layer 330 is exposed as the outermost layer of the display apparatus 1 at a temperature of 85 °C and a humidity of 85 % for 504 hours, the second inorganic encapsulation layer 330 may have an oxidation rate of greater than 0.7 Å/h and less than 2.3 Å/h.

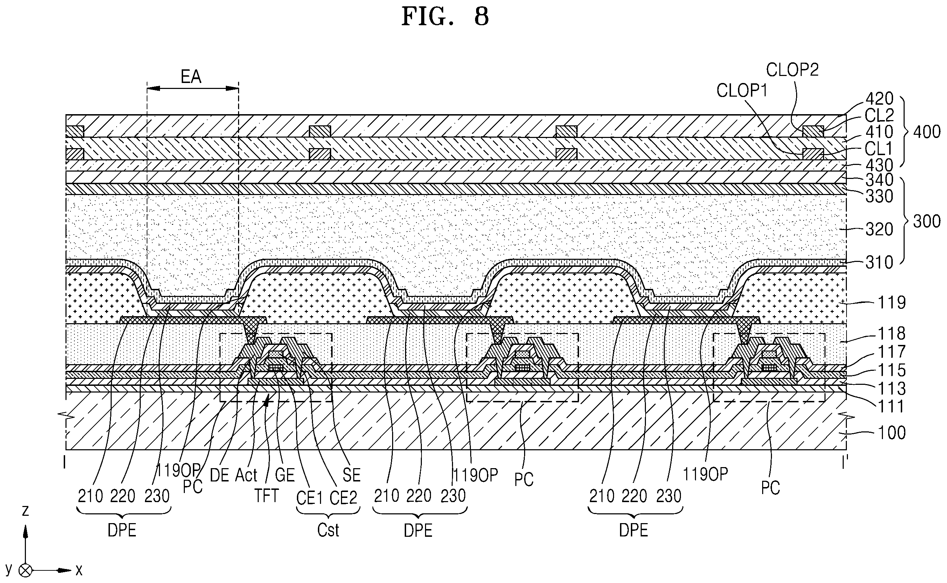

FIG. 8 is a schematic plan view illustrating a portion of the display apparatus 1 according to an embodiment. Because the display apparatus 1 according to the present embodiment is similar to the display apparatus 1 described above with reference to FIGS. 1 to 7, differences from the display apparatus 1 described above with reference to FIGS. 1 to 7 are mainly described. In FIG. 8, because the same reference numerals as those in FIGS. 1 to 7 denote the same members, redundant descriptions thereof are omitted.

The encapsulation layer 300 of the display apparatus 1 described above with reference to FIGS. 1 to 7 includes the first inorganic encapsulation layer 310, the organic encapsulation layer 320, and the second inorganic encapsulation layer 330, and the organic encapsulation layer 320 is disposed between the first inorganic encapsulation layer 310 and the second inorganic encapsulation layer 330. The encapsulation layer 300 of the display apparatus 1 according to the present embodiment also includes the first inorganic encapsulation layer 310, the organic encapsulation layer 320, and the second inorganic encapsulation layer 330, and the organic encapsulation layer 320 is disposed between the first inorganic encapsulation layer 310 and the second inorganic encapsulation layer 330.

However, the encapsulation layer 300 of the display apparatus 1 according to the present embodiment may further include a third inorganic encapsulation layer 340. The third inorganic encapsulation layer 340 may be disposed on the second inorganic encapsulation layer 330. Similar to the second inorganic encapsulation layer 330, the third inorganic encapsulation layer 340 may also include at least one of silicon nitride (SiNx) or silicon oxynitride (SiO_{X}N_{Y}). In an embodiment, the density of the third inorganic encapsulation layer 340 may be higher than the density of the second inorganic encapsulation layer 330. For example, the density of the third inorganic encapsulation layer 340 may be 2.03 g/cm³ to 2.2 g/cm³.

Accordingly, the encapsulation layer 300 may better prevent ambient moisture or oxygen from penetrating toward the display element DPE. That is, the encapsulation layer 300 may be sufficient to protect the display element DPE from ambient moisture or oxygen. Accordingly, dark spots may not occur on the display apparatus 1 due to ambient moisture or oxygen.

According to one or more embodiments, a display apparatus, in which the possibility of defects occurring during a manufacturing process is effectively reduced, and an electronic device including the same may be implemented. Embodiments of the disclosure are not limited by such an effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus comprising:
a display element on a substrate; and
an encapsulation layer covering the display element, wherein the encapsulation layer comprises a first inorganic encapsulation layer, a second inorganic encapsulation layer, and an organic encapsulation layer between the first inorganic encapsulation layer and the second inorganic encapsulation layer,
wherein the organic encapsulation layer has a relative permittivity of 2.3 to 2.7, and
the second inorganic encapsulation layer has a density of greater than 1.8 gram per cubic centimeters (g/cm³) and less than 2.03 g/cm³.

2. The display apparatus of claim 1, wherein the second inorganic encapsulation layer is in direct contact with the organic encapsulation layer.

3. The display apparatus of claim 1 or claim 2, wherein the second inorganic encapsulation layer has a compressive stress of greater than 60 megapascals (MPa) and less than 180 MPa.

4. The display apparatus of any of claims 1 to 3, wherein the second inorganic encapsulation layer comprises at least one of silicon nitride or silicon oxynitride.

5. The display apparatus of claim 4, wherein, when the second inorganic encapsulation layer is exposed as an outermost layer of the display apparatus at a temperature of 85 degrees in Celsius (°C) and a humidity of 85 % for 504 hours, the second inorganic encapsulation layer has an oxidation rate of greater than 0.7 angstroms per hours (Å/h) and less than 2.3 Å/h.

6. The display apparatus of any of claims 1 to 5, wherein the organic encapsulation layer has a modulus of greater than 60 MPa and less than 1 gigapascal (GPa).

7. The display apparatus of any of claims 1 to 6, further comprising a touch sensor layer on the encapsulation layer.

8. The display apparatus of claim 7, wherein the touch sensor layer comprises a touch conductive layer and a touch insulating layer covering the touch conductive layer.

9. The display apparatus of any of claims 1 to 8, wherein the first inorganic encapsulation layer comprises at least one of silicon oxide, silicon nitride, or silicon oxynitride.

10. The display apparatus of any of claims 1 to 9, further comprising:
a third inorganic encapsulation layer on the second inorganic encapsulation layer,
wherein the third inorganic encapsulation layer has a density higher than the density of the second inorganic encapsulation layer.

11. The display apparatus of claim 10, wherein the third inorganic encapsulation layer has a density of 2.03 g/cm³ to 2.2 g/cm³.

12. An electronic device comprising:
the display apparatus of any of claims 1 to 11; and
a housing accommodating the display apparatus and forming an exterior of the electronic device.
